# EUROPEAN PATENT APPLICATION

(11) **EP 2 309 534 A1**
(43) Date of publication of application: **13.04.2011**
(21) Application number: 10175501.5
(22) Date of filing: 06.09.2010
(51) Int. Cl.: H01L 21/337, H01L 29/10, H01L 29/808

(54) **Depleted top gate junction field effect transistor (DTGJFET)**

(30) Priority: 08.10.2009 US 249716 P; 18.03.2010 US 726855
(71) Applicant: Intersil Americas Inc., Milpitas, CA 95035 (US)
(72) Inventor: Gibby, Aaron, Palm Bay, FL 32905 (US)
(74) Representative: Fleuchaus, Michael A.

(57) **Abstract**

A junction field effect transistor semiconductor device and method include a top gate interposed between a source region and a drain region, and which extend across an entire surface of the channel region from the source region to the drain region. Top gate doping can be configured such that the top gate can remain depleted throughout operation of the device. An embodiment of a device so configured can be used in precision, high-voltage applications.

## Description

### Cross Reference to Related Application

This invention claims priority to U.S. Provisional Patent Application Serial No. 61/249,716 filed October 8, 2009.

### Description of the Invention

The present teachings relate to the field of semiconductor device manufacture, and more particularly to a method and structure for a junction field effect transistor (JFET) device.

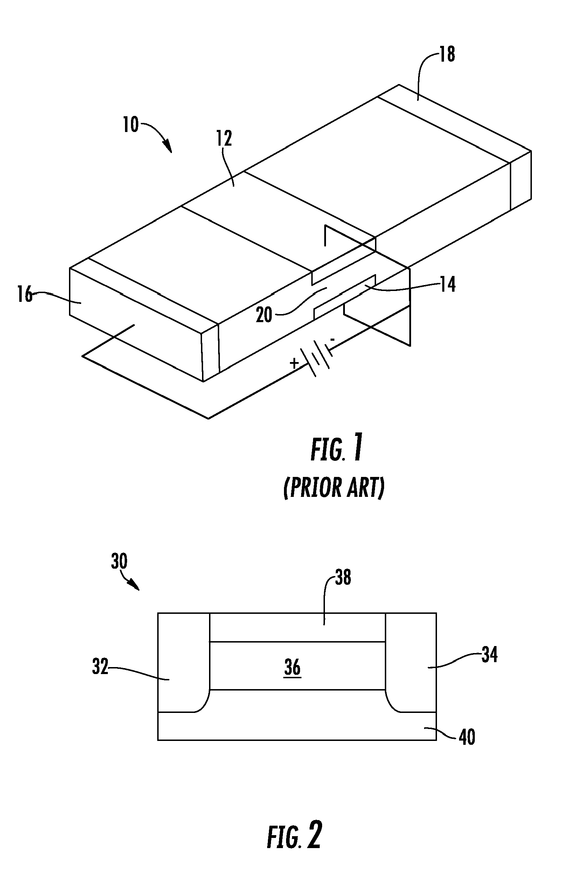

The design and function of junction field effect transistor devices (JFETs) is well established. FIG. 1 is a perspective view of a conventional N-channel JFET device 10 including a top gate 12, a bottom gate 14, a source region 16, a drain region 18, and a channel region 20 interposed between the top gate 12 and the bottom gate 14. Depending on the application, the degree of doping may vary, while the doping polarity (i.e. N- or P-type) will remain the same for all applications. In an N-channel device in a high voltage application, for example, the top gate 12 can be moderately doped to a P-type conductivity, the bottom gate 14 can also be moderately doped to a P-type conductivity, the source region 16 and drain region 18 can be moderately to heavily doped to an N-type conductivity (i.e. doped to a "N+" conductivity), while the bulk semiconductor region of the transistor and the channel region 20 are lightly doped to an N-type conductivity (i.e. doped to an "N-" conductivity). Doping levels tend to be heavier in lower voltage applications.

Electron flow through the device occurs by applying a voltage across the source 16 to the drain 18 without gate bias. With an increasing negative bias applied to the gate 12, 14 (i.e. an increasingly negative gate-source voltage V_{GS}), electron flow through the device becomes more restricted due an increased resistance in the channel region. The increased resistance results from formation of depletion regions in the channel region around the top and bottom gates. Once V_{GS} is sufficiently negative, electron conduction ceases due to "pinch-off' which occurs upon reaching device saturation.

In a JFET device designed for precision high-voltage applications (i.e. a device operating at a drain-source voltage "V_{DS}" of at least 10 V), noise can be problematic. The moderately doped top gate is a high-resistance region because it is pinched between the silicon surface and the channel. As voltage is applied to the gate, current flows in this pinched region to modulate the width of the depletion region between the top gate and the channel. The high resistance of this region adds thermal noise to the input signal, which is amplified in the output signal. Noise can be somewhat mitigated by increasing the dopant concentration in the top gate, but this limits the voltage which can be applied to the device.

Furthermore, a breakdown voltage of the device must be much larger than the maximum operating voltage to prevent large gate currents resulting from ionization current generated in the channel. lonization current further limits the implantation of the a conventional JFET device to cascoded circuit applications to limit the input bias current.

A JFET device design which overcomes these problems during high voltage and precision operations would be desirable.

The following presents a simplified summary in order to provide a basic understanding of some aspects of one or more embodiments of the present teachings. This summary is not an extensive overview, nor is it intended to identify key or critical elements of the present teachings nor to delineate the scope of the present teachings. Rather, its purpose is to present one or more concepts in simplified form as a prelude to the detailed description presented later.

An embodiment of the present teachings can include a semiconductor device having a source region, a drain region, a channel region interposed between the source region and the drain region, and a top gate interposed between the source region and the drain region, wherein the top gate overlies the channel region across an entire extent from the source region to the drain region.

Another embodiment of the present teachings can include a method for forming a semiconductor device which includes implanting a source region, a drain region, and a channel region into a substrate (such as a semiconductor wafer, wafer section, epitaxial layer, etc.), wherein the channel region is interposed between the source region and the drain region, and implanting a top gate into the substrate, wherein the implanted top gate overlies the channel region across an entire extent from the source region to the drain region.

The accompanying drawings, which are incorporated in and constitute a part of this specification, illustrate embodiments of the present teachings and together with the description, serve to explain the principles of the present teachings. In the figures:

FIG. 1 is a perspective view of a conventional junction field effect transistor (JFET) device;

FIG. 2 is a cross section depicting a JFET device in accordance with an embodiment of the present teachings;

FIG. 3 is a plan view of the FIG. 2 embodiment;

FIG. 4 is a perspective view of the embodiment of FIGS. 2 and 3;

FIG. 5 depicts doping concentration profiles for a conventional JFET and a JFET device in accordance with an embodiment of the present teachings;

FIG. 6 is a perspective view of a first conventional device;

FIG. 7A is a plan view, and FIG. 7B is a cross section along A-A of FIG. 7A, of a second conventional device;

FIG. 8 is a perspective view of a JFET device according to one embodiment of the present teachings;

FIG. 9 depicts a comparison of cross sections for a conventional JFET device (top) to a cross section for a JFET device according to one embodiment of the present teachings;

FIG. 10 depicts a perspective view of a JFET device having a single gate contact and a top gate dopant gradient according to another embodiment of the present teachings;

FIG. 11 is a cross section of a simulated JFET device in accordance with an embodiment of the present teachings, and includes a top gate dopant gradient with a higher dopant concentration near the source region and a lower dopant concentration near the drain region;

FIG. 12 is a graph depicting a simulated gate current for a conventional JFET device and devices according to embodiments of the present teachings; and

FIG. 13 is a graph depicting simulated drive currents for a conventional JFET and for a JFET device according to an embodiment of the present teachings.

It should be noted that some details of the FIGS. have been simplified and are drawn to facilitate understanding of the inventive embodiments rather than to maintain strict structural accuracy, detail, and scale.

Reference will now be made in detail to the present embodiments (exemplary embodiments) of the present teachings, examples of which are illustrated in the accompanying drawings. Wherever possible, the same reference numbers will be used throughout the drawings to refer to the same or like parts.

An embodiment of the present teachings includes a junction field effect transistor (JFET) which can be used in precision, high-voltage applications, as well as other applications. For purposes of the present teachings, a "high-voltage" application is one wherein the device operates at a V_{DS} voltage of at least 10 V. An embodiment of the present teachings includes a JFET device having a top gate which is very lightly doped and thus adapted to be fully depleted throughout device operation, and thus is referred to herein as a "depleted top gate" JFET (DTGJFET). During operation, this depletion region can completely fill the top gate volume and extend beyond the edge of the channel implant so that current does not flow in this region and noise is reduced or eliminated. This lightly doped P-type gate region is formed above, below, and on two sides of the channel region, with the source and drain formed on the remaining two sides of the DTGJFET channel.

In an additional aspect of a disclosed device, the light top gate doping can increase the allowable voltage which can be applied to the gate such that the DTGJFET device can be used in precision, high-voltage applications. In contrast with conventional JFET (CJFET) devices which are limited to a maximum V_{DS} voltage of about 30 V in precision applications, a device formed in accordance with the present teachings can operate at a V_{GS} voltage of about 80 V or more.

It should be noted that while various embodiments are described with reference to an N-channel JFET device (i.e. N-JFET), the present teachings are equally applicable to a P-channel JFET device (i.e. P-JFET). Such a device, or a complementary circuit including both N-type and P-type DTGJFET devices, and various additional circuits including other devices, can be designed and manufactured by one of ordinary skill in the art from the present teachings herein.

FIG. 2 depicts a cross section of a DTGJFET device 30 across a source 32, drain 34, channel 36, top gate 38, and bottom gate 40. In an embodiment, the top gate 38 is formed within the semiconductor layer (i.e. within the substrate) and interposed between the source 32 and the drain 34. The top gate extends across an entire surface (the entire extent) of the channel 36 between the source 32 and drain 34. As depicted, a first vertical sidewall of the top gate 38 contacts a vertical sidewall of the source region 32, and a second vertical sidewall of the top gate 38 contacts a vertical sidewall of the drain region 34.

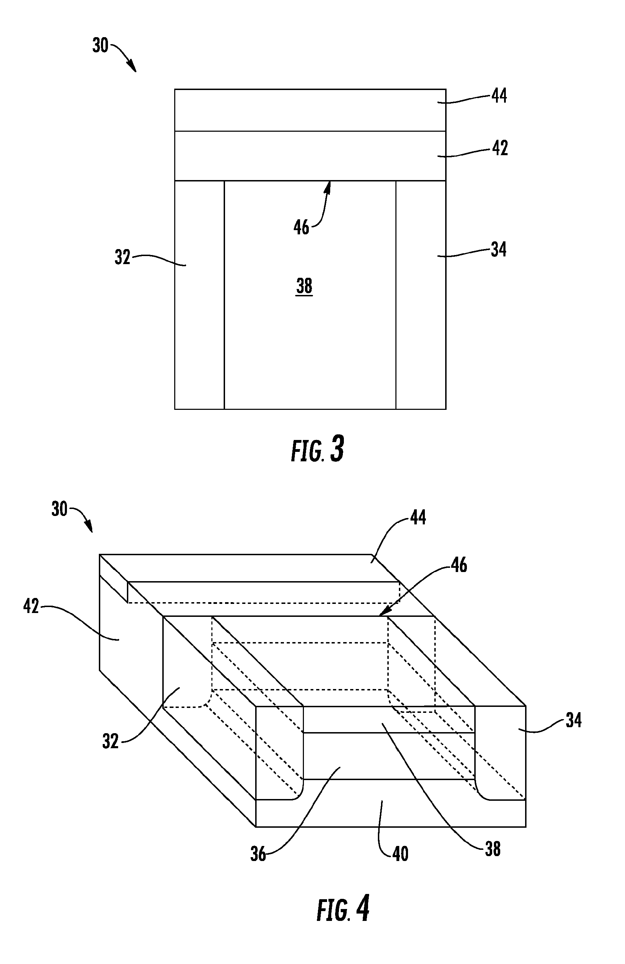

FIG. 3 depicts a plan view of the DTGJFET device 30 of FIG. 2, which includes the source 32, drain 34, top gate 38, bulk silicon 42 which is a continuation of the top and bottom gates and is similarly doped, and a gate contact region 44. The bulk silicon 42 can be formed by doping to a P-type concentration during a P-well implant. FIG. 3 further depicts an edge 46 of the channel implant which abuts the P-type doping which forms the bulk silicon region 42 to form a P-N junction.

FIG. 4 is a perspective view of the device of FIGS. 2 and 3 and depicts the DTGJFET device 30 including the source region 32, drain region 34, channel region 36, top gate 38, bottom gate 40, bulk silicon 42, gate contact 44, and edge 46 of the channel implant. In various uses, the term "bulk silicon" may refer to a dopant tub, the substrate, or even a dielectric isolated tub, such as in a silicon-on-insulator (SOI) process. The term "substrate" can include a semiconductor wafer, an epitaxial layer, a semiconductor wafer with an overlying epitaxial layer, etc.

As depicted in FIG. 4, P-type material which functions as the transistor gate surrounds the channel region on four sides. The top gate 38 is formed on the upper surface (i.e. the upper surface as depicted in FIGS. 3 and 4) of the channel region 36, the bottom gate 40 is formed below the lower surface of the channel region 36, and the bulk silicon 42 is formed laterally at two directions relative to the channel region 36. The source 32 and drain 34 are formed at the remaining two sides of the channel region 36.

In an embodiment of a DTGJFET of the present teachings, the top gate can be implanted to a minimal doping concentration. In contrast to a conventional JFET device which can have a top gate doped with P-type material such as boron to a concentration of between about 1 E17 atoms/cm³ and about 1 E18 atoms/ cm³, the top gate in accordance with one embodiment can be doped to a concentration below about 1 E16 atoms/cm³. In one embodiment, the lower doping can result from omitting the top gate implant of conventional processes. A doping energy of the channel implant can be increased so that when it is implanted into the P-well, a region of lightly-doped P-type material still exists between the channel implant and the surface of the device to form the top gate. By properly choosing the energy of the channel implant, the concentration of P-type material which forms the top gate can be sufficiently low so that the top gate is fully depleted by the PN junction formed between the channel and this top gate, without applied bias. An exemplary implant energy for a phosphorus ion of between about 300 KeV and about 500 KeV would result in a channel region starting at about 5000 Å below the silicon surface, such that the top gate would remain from the silicon surface to about 5000 Å below the silicon surface.

The table below shows exemplary peak doping levels for conventional JFETs and for an embodiment of a DTGJFET device:

**Table 1 Doping Concentrations of Conventional JFETs vs. an Embodiment of a DTGJFET**

| **Structure** | **Conventional JFET (CJFET) Doping Concentrations (atoms/cm³)** | **DTGJFET Doping Concentrations (atoms/cm³)** |
|---|---|---|
| Source | 1E19 to 1E21 | 1E19 to 1E21 |
| Drain | 1E19 to 1E21 | 1E19 to 1E21 |
| Channel* | 1 E16 to 1 E17 | 1E16 to 1E17 |
| Top Gate | 1E17 to 1E18 | below 1E16 |
| Bottom Gate | 1E15 to 1E17 | 1E15 to 5E16 |
| Gate Contact (ex. region 44, FIG. 4) | 1E19 to 1E21 | 1E19 to 1E21 |
| *Channel doping concentration depends on the application and required pinch off voltage (V_{P}). | | |
| These exemplary levels reflect a device with a V_{P} of between about 1 V and 3V, and can vary with a higher or lower desired V_{P}. | | |

While the device depicted comprises an embodiment having a gate contact on only one side, other embodiments having gate contacts on both side of the channel are also contemplated.

In another embodiment, a device with a depleted top gate can be manufactured using a gate implant. Although likely more expensive than the embodiment described above due to an additional mask which exposes the top gate and blocks the implant from other regions of the device, this additional gate implant may be necessary where a high-energy implanter is not available or the implant is of poor quality. In this case, without a separate gate implant, the channel implant may extend to the surface of the device to result in an insufficient top gate doping level. Thus in this case, the P-well implant cannot reliably provide the top gate. In this embodiment, a top gate implant would create a thin P-type region along the surface of the device to form the top gate.

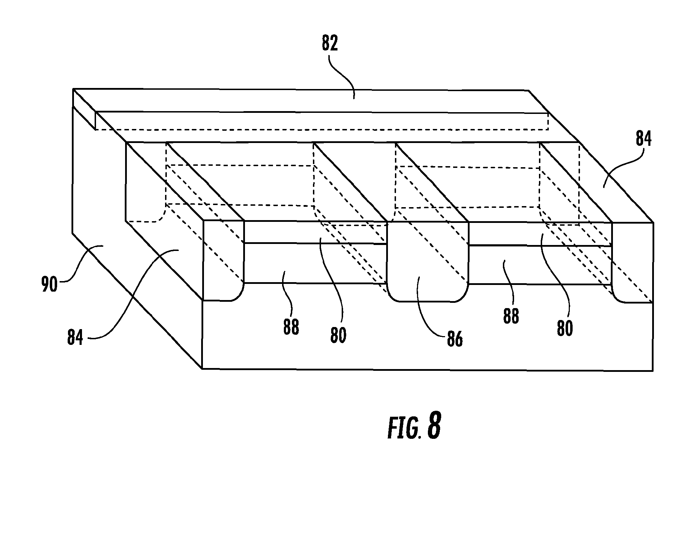

A contact to the channel and the gate can be provided in a number of different ways. For example, in a cost-effective process, a single implant can be used to form the source 32 and drain 34 to provide a doped conductive pathway from the channel to the upper surface of the silicon. In another embodiment, contact to the channel can be made using multiple implants in the source 32 and drain 34 regions to reduce the series resistance of the contact or to modify the doping gradient. Connection of the source 32 and drain 34 with metallization is not necessary in either design, as the device can share a source or drain diffusion region with a neighboring device. FIG. 8, described below, depicts two such devices that can share a drain diffusion. The gate contact 44 can be formed over the bulk silicon 42 by using a masked P-type implant to form a P+ region with a concentration of between about 1 E19 atoms/cm³ and about 1 E21 atoms/cm³ to result in the gate contact 44 as depicted in FIG. 4.

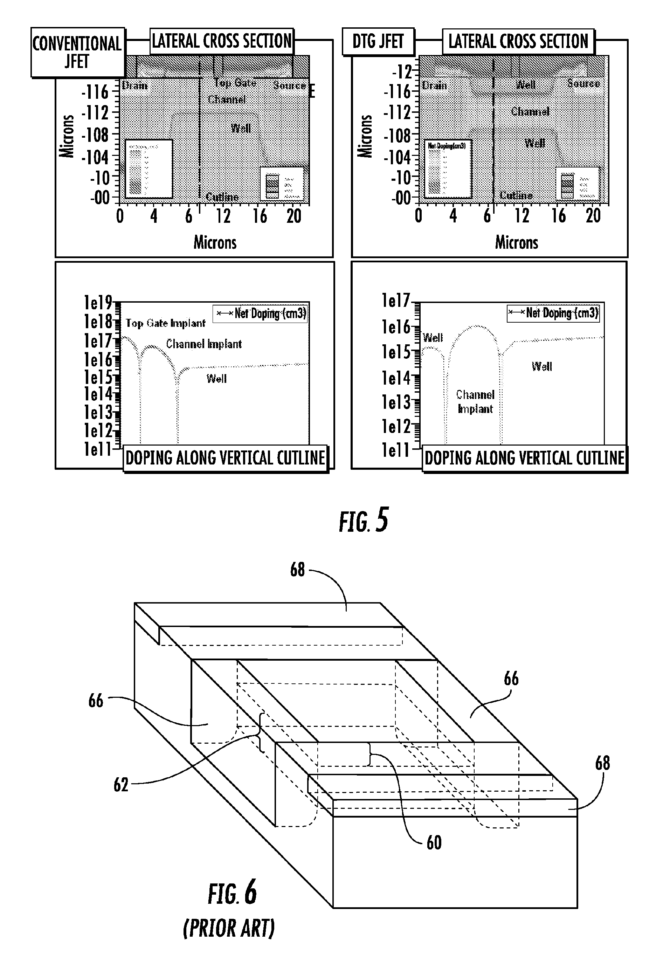

FIG. 5 compares simulated cross-sections taken along the direction of current flow (top) and vertical doping profiles (bottom) of a CJFET (left) and a DTGJFET (right). The doping profiles in the lower two depictions are taken along the dashed vertical lines in the upper depictions. In the bottom two graphs, the surface of the silicon is on the left side with increasing depth moving toward the right side. One feature of the DTGJFET is the light doping near the surface of the wafer, about 1 E15 atoms/cm³, compared to heavier doping in a conventional JFET, about 1E17 atoms/cm³. As depicted, top gate peak doping concentration of the conventional device is higher than the peak doping concentration of the channel. With an embodiment of the present device according to FIG. 5, peak top gate doping concentration is lower than the peak doping concentration of the channel. Surface segregation that lowers the B doping near the surface (top 500Å or so) is a secondary effect. A lower top gate doping in the DTGJFET can greatly reduce gate leakage current of the device while increasing the breakdown voltage. In addition, the low doping of the top gate can improve noise performance by reducing or preventing current flow through the high resistance top gate. Instead, the top gate can be fully depleted and is therefore capacitively coupled to the backgate.

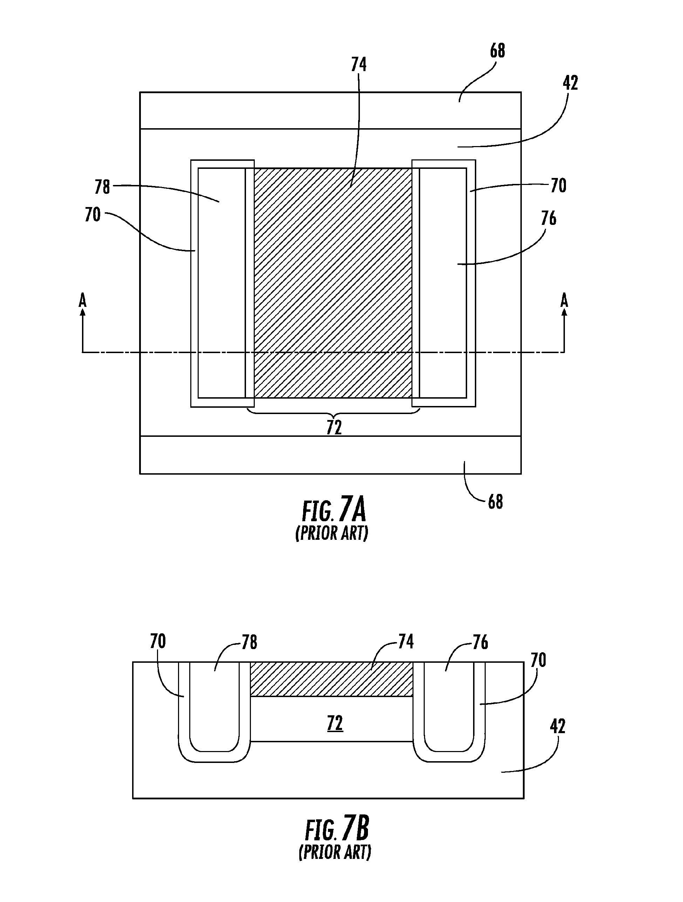

FIGS. 6, 7A, and 7B depict two examples of conventional JFET layouts. The structure of FIG. 6 is formed using a blanket implant for the top gate which forms a peak doping concentration in the top gate 60 which is higher than the peak doping in the channel 62. This device, however, can suffer from low breakdown voltage and the onset of high gate current at low voltages. Thus, it may be limited to cascoded applications. FIG. 6 further depicts source/drain regions 66 and two gate contacts 68. The depiction of the device plan view of FIG. 7A, depicted in the cross section of
FIG. 7B along A-A of FIG. 7A, includes two openings 70, referred to as "drain extensions," in the implanted region of the channel 72. In this device, the top gate 74 has a higher peak doping concentration than the channel, and the drain extensions 70 have a lower net doping concentration than the source 76 and drain 78 regions. The drain extensions allow for a higher breakdown voltage at the cost of device area, and can further result in a device which suffers from high gate current. Additionally, the high resistance of the gate requires two gate contacts 68 to minimize gate resistance, thus increasing the device area.

FIG. 8 depicts a DTGJFET layout in accordance with one embodiment of the present teachings. The low resistance of the gate 80 can result in the use of a single gate contact 82. This device can also be formed without the use of a top gate implant which can reduce manufacturing costs by eliminating a mask step and associated wafer handling. As depicted in FIG. 8, the layout includes a two-stripe device with two source regions 84 feeding one drain region 86. Also depicted are channel regions 88 and bulk silicon region 90. The bottom gates are provided under the channel regions by the bulk silicon or an implanted well in which the transistor resides.

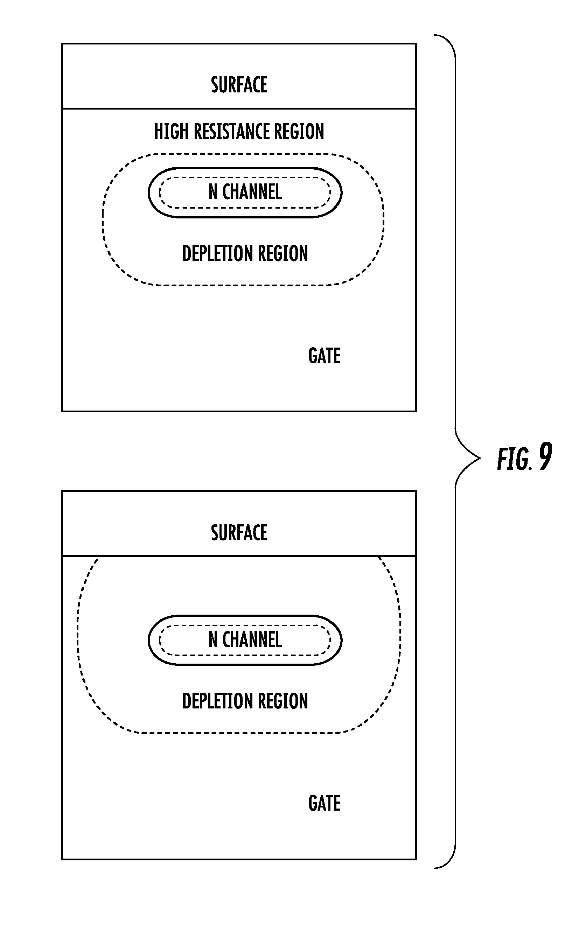

FIG. 9 compares layouts and cross sections of a conventional JFET device (top) and a DTGJFET device (bottom). The cross-sections are taken across the channel regions in a direction which is perpendicular to the direction of current flow. FIG. 9 highlights differences in depletion regions between a typical conventional JFET (top) and an embodiment of the DTGJFET (bottom). The conventional device includes a high resistance region extending from the top of the depletion region formed during device operation to the upper surface of the semiconductor layer. The DTGJFET embodiment depicted includes a depletion region which extends all the way to the surface of the semiconductor layer, and does not have a high resistance region.

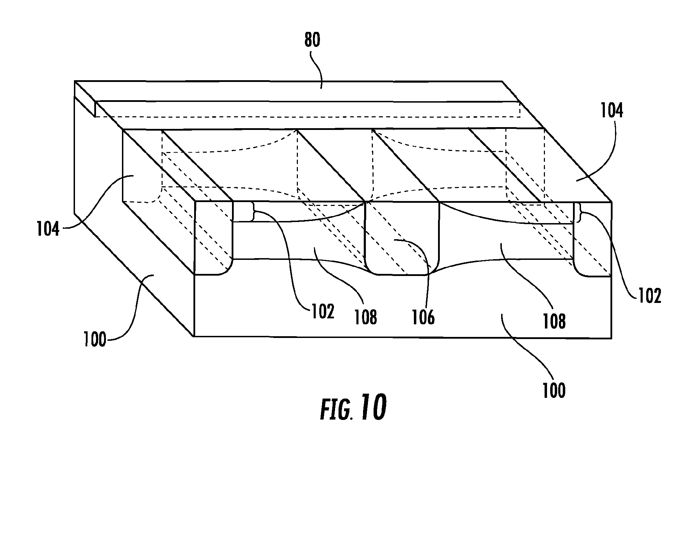

Another embodiment for a DTGJFET device is depicted in FIG. 10. In this layout, a P-well implant 100 can be formed to provide top gates having a graded doping profile. The P-well implant mask can be formed with an opening such that dopants from the well implant are implanted into a portion of the length of the top gates 102 at a first region near the source regions 104, and not at a second location near the drain 106. A subsequent diffusion results in movement of the well implant ions across the top gates 102 toward the shared drain 106 to result in a graded top gate doping profile. A first peak concentration of the dopant will thus be higher in the top gates 102 at a first location toward (near) the sources 104 than a second peak concentration of the dopant near the drain 106 at the same depth within the substrate. For example, the first peak concentration of the dopant within the top gate at the first location toward the source region can be about 2E15 atoms/cm³ while the second peak concentration of the dopant within the top gate at the second location toward the drain region can be about 1E14 atoms/cm³. In another embodiment, the first peak concentration of the dopant can be 2E15 atoms/cm³ or greater and the second peak concentration of the dopant can be 1 E14 atoms/cm³ or less. However, other first and second peak dopant concentrations are contemplated where the first peak concentration is greater than the second peak concentration. While not intending to be bound by theory, the method can result in a structure which includes tapering of the channels 108 during device operation, with the thinnest portion of the channel being located toward the source 104. As a result, during device operation, the device will "pinch" toward the source region to modulate the channel current. In a conventional device, pinch-off normally occurs toward the drain. This effect can result in a reduction of the ionization current and gate current, thereby allowing the use of the DTGJFET in non-cascoded applications.

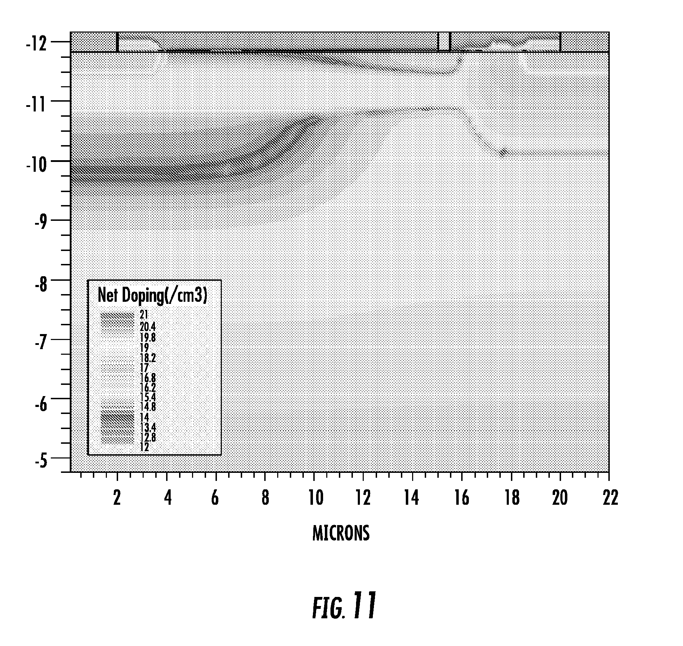

FIG. 11 depicts a simulated cross section of the modified DTGJFET layout of FIG. 10 device, indicating dopant concentrations. The lateral diffusion of the well implant in the top gate away from the higher concentration region near the source toward the drain results in a graded concentration profile. During device operation, the graded profile causes the channel to "pinch" near the source, and relaxes the channel width towards the drain. The depth units along the y-axis are in microns, and are measured within a grown epitaxial layer relative to the starting surface of the wafer, which has a value of zero.

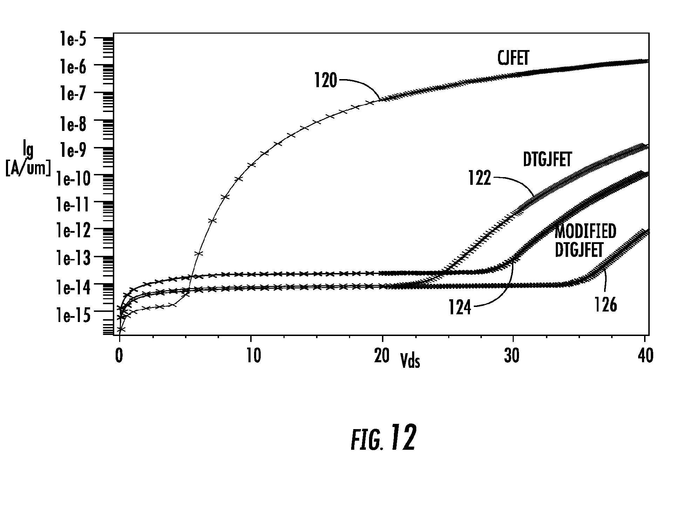

FIG. 12 is a graph depicting a simulated gate current (I_{G}, in amps/micrometer) as a function of applied drain bias (V_{DS}). The conventional JFET curve 120 is matched to real data. Higher ionization current causes a large increase in gate current, which corresponds to an increase in bias current for JFET front end amplifiers. The curve for the DTGJFET shows a significant reduction in gate current at a given voltage. Using the modified structure depicted in FIG. 10, the gate current can be further reduced as depicted in the graphs for the modified DTGJFET. Increasing the spacing between the well implant and the drain (i.e. increasing the device length) shifts the curve 124 to curve 126.

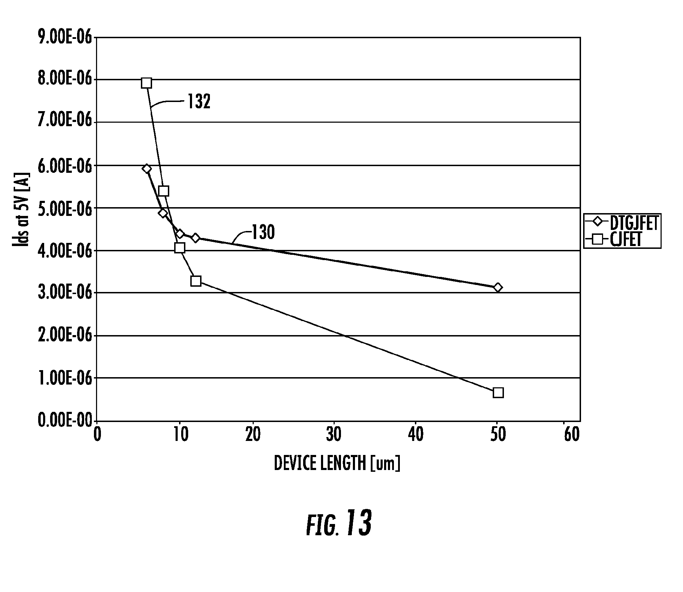

FIG. 13 is a graph depicting drive current at an applied drain bias (V_{DS}) of 5V for a DTGJFET device 130 in accordance with FIGS. 10 and 11 and with a conventional JFET 132. Curve 130 for the DTGJFET shows a reduced sensitivity of drain current to device length compared to the curve 132 of the JFET device. This can result in improved manufacturability at short lengths and increased drive current for large devices (which benefit from reduced gate current).

Thus in various embodiments of the present teachings, the top gate can be fully depleted throughout operation of the device. Depletion can occur with no bias applied, for example during the simultaneous application of 0V to all of the source region, drain region, and top gate. Because of low dopant concentrations in the top gate, which can extend all the way across the channel from the source to the drain, and contact the channel all the way across, depletion occurs without applied bias. Even though the top gate is a high-resistivity region resulting from low doping, little or no current flows through the top gate which would contribute thermal noise to the device. The light doping in the gate regions leads to a large breakdown voltage. This breakdown voltage is large enough to provide the margins necessary to limit the ionization current that causes high levels of gate leakage. Furthermore, the light doping leads to wider depletion regions, which reduces the gate-channel capacitance, and increases the speed of the device.

In an embodiment, optional removal of the top gate implant can have an added benefit of removing a masking step from the fabrication process, thereby reducing manufacturing costs.

In various embodiments, the use of a lateral diffusion region to define the gate can further decrease the ionization current and gate current, and allow an expanded set of applications and more flexibility in circuit design.

An exemplary method to form an N-channel DTGJFET device can include various steps. It will be appreciated that the steps below can be performed in orders other than that described, and that other processing steps can be performed before, after, or during each described step. For example, one or more drive/anneal steps can be performed, as well as an activation anneal at the end of the process.

A first step can include at least one method of providing gate doping by implanting bulk silicon to an appropriate dopant concentration, growing an epitaxial layer with appropriate doping concentrations, and/or implanting a well such as a P-well in a semiconductor wafer or epitaxial layer. Next, an optional mask and implant of N-type source and drain extension regions can be performed. Subsequently, a patterned channel mask can be formed and an N-channel implant through the patterned channel mask can be performed.

To form the top gate, various methods can be used. For example, a P-type implant can be performed through the channel mask. The top gate can also be formed using a separate patterned top gate mask, which is implanted through with P-type dopants to form the top gate. Additionally, doping resulting from the bulk silicon implant may be sufficient to provide the top gate, with the channel implant burying the channel below the top gate using appropriate implant energies.

Subsequently, the N-type source and drain regions can be masked and implanted, then the P-type gate contact can be masked and implanted.

Notwithstanding that the numerical ranges and parameters setting forth the broad scope of the present teachings are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less than 10" can assume negative values, e.g. - 1, -2, -3, -10, -20, -30, etc.

While the invention has been illustrated with respect to one or more implementations, alterations and/or modifications can be made to the illustrated examples without departing from the spirit and scope of the appended claims. In addition, while a particular feature of the invention may have been disclosed with respect to only one of several implementations, such feature may be combined with one or more other features of the other implementations as may be desired and advantageous for any given or particular function. Furthermore, to the extent that the terms "including," "includes," "having," "has," "with," or variants thereof are used in either the detailed description and the claims, such terms are intended to be inclusive in a manner similar to the term "comprising." The term "at least one of' is used to mean one or more of the listed items can be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. Finally, "exemplary" indicates the description is used as an example, rather than implying that it is an ideal. Other embodiments of the invention will be apparent to those skilled in the art from consideration of the specification and practice of the invention disclosed herein. It is intended that the specification and examples be considered as exemplary only, with a true scope and spirit of the invention being indicated by the following claims.

Terms of relative position as used in this application are defined based on a plane parallel to the conventional plane or working surface of a wafer or substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

A semiconductor device of the invention comprises a source region within a semiconductor layer, a drain region within the semiconductor layer, a channel region within the semiconductor layer interposed between the source region and the drain region and a top gate within the semiconductor layer interposed between the source region and the drain region, wherein the top gate overlies the channel region across an entire extent from the source region to the drain region and is adapted to be fully depleted throughout device operation.

Preferably, in the semiconductor device of the invention, a lower surface of the top gate further contacts the channel region across the entire extent from the source region to the drain region.

The semiconductor device of the invention further comprises a transistor gate which comprises the top gate, wherein the transistor gate further comprises a bottom gate having an upper surface which contacts a lower surface of the channel region across an entire extent of the channel region which is interposed between the source region and the drain region.

Preferably, the transistor gate further comprises a first portion located at a first lateral location relative to the channel region which contacts the channel region and a second portion located at a second lateral location relative to the channel region which contacts the channel region, wherein the transistor gate thereby contacts four sides of the channel region.

Preferably, in the semiconductor device of the invention, the channel region comprises a first type dopant having a first type conductivity at a peak concentration of between about 1 E16 atoms/cm³ and about 1 E17 atoms/cm³; and the top gate comprises a second type dopant having a second type conductivity opposite of the first type conductivity at a peak concentration about 1 E16 atoms/cm³.

Preferably, in the semiconductor device of the invention, the top gate comprises a dopant gradient extending from the source region to the drain region, wherein a first peak concentration of the dopant toward the source region is higher than a second peak concentration of the dopant toward the drain region.

Preferably, in the semiconductor device of the invention, during device operation, the top gate is completely depleted throughout operation of the device.

Preferably, in the semiconductor device of the invention, the top gate is completely depleted without applied bias.

Preferably, in the semiconductor device of the invention, during simultaneous application of 0.0 Volts to all of the source region, the drain region, and the top gate, the top gate is completely depleted.

## Claims

1. A method for forming a semiconductor device, comprising:
implanting a source region, a drain region, and a channel region into a substrate,
wherein the channel region is interposed between the source region and the drain region; and
implanting a top gate into the substrate, wherein the implanted top gate overlies the channel region across an entire extent from the source region to the drain region

2. The method of claim 1, wherein implanting the top gate further comprising implanting the top gate such that a lower surface of the top gate contacts the channel region across the entire extent from the source region to the drain region.

3. The method of claim 1 further comprising a transistor gate comprising the top gate, wherein formation of the transistor gate comprises:
implanting a bottom gate wherein, subsequent to implanting the channel region, an upper surface of the bottom gate contacts a lower surface of the channel region across an entire extent of the channel region.

4. The method of claim 3, further comprising:
implanting a transistor gate portion wherein, subsequent to implanting the channel region, a first portion of the transistor gate is located at a first lateral location relative to the channel region which contacts the channel region and a second portion is located at a second lateral location relative to the channel region which contacts the channel region.

5. The method of claim 1, wherein:
implanting the channel region comprises doping the channel region with a first type dopant having a first type conductivity at a peak concentration of between about 1 E 16 atoms/cm³ and about 1E17 atoms/cm³; and
implanting the top gate comprises doping the top gate with a second type dopant having a second type conductivity opposite of the first type conductivity at a peak concentration of about 1E16 atoms/cm³.

6. The method of claim 1, wherein:
implanting the top gate comprises doping the top gate to a dopant gradient extending from the source region to the drain region, wherein a first peak concentration of the dopant toward the source region is higher than a second peak concentration of the dopant toward the drain region at the same depth within the substrate.

7. The method of claim 1, wherein the source region, the drain region, the channel region, and the top gate are implanted such that, during device operation, the top gate is completely depleted throughout operation of the semiconductor device.

8. The method of claim 1, wherein the source region, the drain region, the channel region, and the top gate are implanted such that, during simultaneous application 0.0 Volts to all of the source region, the drain region, and the top gate, the top gate is completely depleted.

9. A semiconductor device comprising:
a source region within a semiconductor layer;
a drain region within the semiconductor layer;
a channel region within the semiconductor layer interposed between the source region and the drain region; and
a top gate within the semiconductor layer interposed between the source region and the drain region, wherein:
the top gate overlies the channel region across an entire extent from the source region to the drain region; and
the top gate comprises a dopant gradient extending from the source region to the drain region, wherein a first peak concentration of the dopant within the top gate at a first location toward the source region is higher than a second peak concentration of the dopant within the top gate at a second location toward the drain region at the same depth within the semiconductor layer.

10. The semiconductor device of claim 9, further comprising:
the first peak concentration of the dopant within the top gate at the first location toward the source region is about 2E15 atoms/cm³; and
the second peak concentration of the dopant within the top gate at the second location toward the drain region is about 1E14 atoms/cm³.

11. The semiconductor device of claim 9, further comprising:
the first peak concentration of the dopant within the top gate at the first location toward the source region is greater than or equal to 2E15 atoms/cm³; and
the second peak concentration of the dopant within the top gate at the second location toward the drain region is less than or equal to 1 E14 atoms/cm³.
